# EUROPEAN PATENT APPLICATION

(11) **EP 2 887 471 A1**
(43) Date of publication of application: **24.06.2015**
(21) Application number: 14198983.0
(22) Date of filing: 18.12.2014
(51) Int. Cl.: H02B 1/052

(54) **Mounting latch**

(30) Priority: 20.12.2013 GB 201322676
(71) Applicant: Control Techniques Ltd, Newtown, Powys SY16 3BE (GB)
(72) Inventor: Hand, Peter Charles, Newtown, Powys SY16 3BE (GB); Cachia, Charles Anthony, Newtown, Powys SY16 3BE (GB)
(74) Representative: Hale, Peter

(57) **Abstract**

A mounting latch for mounting a device to a rail is provided. The mounting latch comprises: a moveable actuator having a profile; a latch mechanism comprising first and second opposed rail engaging members, at least one of the members having a face for causing the member to yield against bias means when the latch mechanism is engaging with the rail; and follower means enabling the at least one member to follow a rotational movement of the actuator such that movement of the actuator in a first direction causes the at least one member to become unlatched from the rail.

## Description

The invention relates to a mounting latch, specifically a mounting latch for mounting electrical devices on to a rail.

### BACKGROUND

It is common for electrical devices to be installed in cabinets in order to prevent exposure of the devices during operation, and also as an effective means for installing the devices in order to save space. Typically, rails such as a DIN rail are used to mount the electrical devices. As cabinets enclose devices and electrical trunking with increasing density, space constraints make it increasingly difficult and potentially dangerous to mount a device in a cabinet.

Known methods of securely fitting devices to rails include levers, tools or sliding means. It is found that these require significantly more free space in the cabinet to perform the action of mounting and demounting the device than the device itself needs when mounted. Further, known solutions are complicated, involving multiple levers or latches to operate in order to achieve the desired mounting. This imposes a maximum density on the installed devices with significant unoccupied space.

On the other hand, this required space to mount a device may not be available due to other mounted devices obstructing access or operation of the required tools or levers. In such instances, it may be necessary to mount devices in a particular sequence. It can then be necessary to remove pre-mounted devices in order to have sufficient room to mount the desired device, which requires significant engineer time to perform the removals and re-mountings. Further, it may also be necessary to remove panels of the cabinet to gain access to desired areas, purely due to the mounting requirements of the device, which again may be time-consuming.

Therefore there is a need for a mounting latch that overcomes the aforementioned problems and allows quick and simple installation of electrical devices.

An invention is set out in the accompanying independent claims. Some preferred features are defined in the dependent claims.

According to an aspect there is provided a mounting latch for mounting a device to a rail. The mounting latch comprises a moveable actuator having a profile, and a latch mechanism comprising first and second opposed rail engaging members. At least one of the members has a face for causing the member to yield against bias means when the latch mechanism is engaging with the rail. The mounting latch further comprises follower means enabling the at least one member to follow the movement of the moveable actuator such that movement of the actuator in a first direction causes the at least one member to become unlatched from the rail.

Such a latch is typically attached to a device, such as an electrical switch block or other component. It is used to mount such devices to a rail or rack. In the following, the mounting latch is described on its own for the sake of simplicity.

The face of the at least one member may be a chamfered face. The use of a chamfered face facilitates the yielding of the member against the bias means when the latch mechanism is engaging with the rail.

Movement of the actuator in a second, opposite direction may cause the at least one member to latch on to the rail.

The profile of the moveable actuator may engage with the follower means, and the movement of the actuator may be a rotational movement.

The profile of the moveable actuator may comprise a detent for retaining the at least one member in a fixed position. The detent may therefore maintain the at least one member in an open position, in order to allow quick and easy placement of the mounting latch on to the rail.

The bias means may comprise a resilient member, for example a spring. Alternatively, other means may be used to provide the bias.

The profile of the moveable actuator may be shaped to enable movement of the at least one member against the bias without movement of the actuator. Therefore, it is possible to move the member against the bias without operation of the actuator at all, avoiding the need for an engineer to operate the mounting latch in any way other than via appropriate placement of the mounting latch against the rail. As a result, latching of the mounting latch on to the rail may be achieved in conditions where space is limited, since no tools or mechanisms need be operated by an engineer in order to attach the device to the rail.

The moveable actuator may be a disc-shaped cam.

The profile of the moveable actuator may comprise first and second profiles on opposite sides of the moveable actuator, and the follower means may comprise first and second follower means for enabling respective first and second members to follow the movement of the moveable actuator. The use of multiple members further minimises the space requirements to fit a device to the rail, since the mounting latch to which the device is attached does not need to be presented perfectly in alignment with the plane of the rail in order to achieve the desired mounting of the mounting latch and device on the rail. The upper member can instead first engage with the rail, followed by the engagement of the lower member with the rail, or vice-versa. Therefore the movement of multiple members allows greater flexibility in the angle between the mounting device and the rail that enables latching of the mounting latch and device on to the rail.

The first follower means may engage with the first profile, and the second follower means may engage with the second profile.

The first and second profiles may comprise respective first and second detents for retaining the respective first and second members in a fixed position. Therefore, both the first and second members may be retained in an open position to facilitate placement of the mounting latch on to the rail.

The first and second profiles may be shaped to allow movement of the respective first and second members against the bias means without movement of the actuator. It is therefore possible to move both members against the bias means without operation of the actuator at all, avoiding the need for an engineer to operate the mounting latch in any way other than via appropriate placement of the mounting latch against the rail. By having two members arranged in this way, appropriate placement is facilitated due to both members being moveable against the bias means simply by pressing the mounting latch on to the rail.

The mounting latch may comprise a pair of opposed latch mechanisms oppositely moveable between latched and unlatched positions with respect to the rail.

### FIGURE LISTING

Embodiments and examples will now be described by way of example with respect to the appended figures of which:
Figure 1 shows a plan view of a mounting latch and a rail;
Figure 2A shows a plan view of the front face of a moveable actuator in an "open" position;
Figure 2B shows a plan view of the rear face of the moveable actuator in the "open" position;
Figure 3A shows a cross-sectional view of the mounting latch in the "open" position;
Figure 3B shows a front view of the mounting latch in the "open" position;
Figure 3C shows a rear view of the mounting latch in the "open" position;
Figure 4A shows a plan view of the front face of the moveable actuator and an upper follower in the "open" position;
Figure 4B shows a plan view of the rear face of the moveable actuator and a lower follower in the "open" position;
Figure 5A shows a plan view of the front face of the moveable actuator and the upper follower in a "closed" position;
Figure 5B shows a plan view of the rear face of the moveable actuator and the lower follower in the "closed" position;
Figure 6A shows a cross-sectional view of the mounting latch in the "closed" position;
Figure 6B shows a front view of the mounting latch in the "closed" position; and
Figure 6C shows a rear view of the mounting latch in the "closed" position.

### DETAILED DESCRIPTION

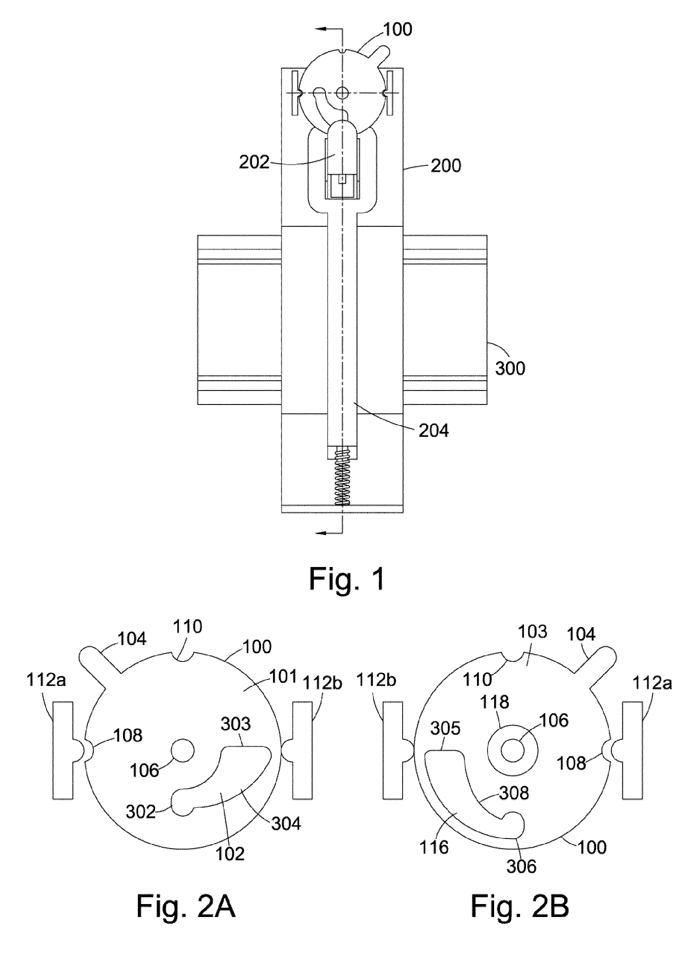

Referring to Figure 1, a mounting latch is shown mounted on a rail such as a DIN rail 300. The mounting latch comprises a moveable actuator such as a cam 100, a body 200, an upper latch 202 and a lower latch 204. The mounting and retention of the mounting latch on to the DIN rail 300 is achieved via an engagement of the upper latch 202 and the lower latch 204 with the DIN rail 300. The upper latch 202 and the lower latch 204 are shaped to engage with the cam 100. When mounted on the DIN rail 300, rotation of the cam 100 disengages the upper latch 202 and the lower latch 204 from the DIN rail 300 by urging them apart and clear of the upper and lower edges of the DIN rail 300, thereby enabling the mounting latch to be demounted from the DIN rail 300.

The structure of the cam 100 can be better understood in relation to Figure 2A. Figure 2A shows a front face 101 of the cam 100. The cam 100 is a circular disk rotationally mounted on the body 200 via a central pivot hole 106 mounted on a pivot arm 212 on the body 200. The cam 100 further comprises a front recess 102, first and second peripheral detents 108 and 110, and a protrusion 104. The front recess 102 defines a cam profile defining movement of the upper latch 202 from an open to a closed position, or vice versa, as the cam 100 is rotated. The front recess 102 comprises a lower surface 304, a detent 302 at one end of the profile, and a front wall 303 at the other, as described in more detail below. The peripheral detents 108 and 110 engage with locating projections 112a and 112b on the body 200. Each locating projection 112a and 112b rides on the peripheral surface of the cam 100 and defines a stop position.

In Figure 2A, the cam 100 is in an "open" position defined by the peripheral detent 108 being engaged with the locating projection 112a. Clockwise rotation of the cam 100 puts it into a "closed" position defined by alignment and engagement of the locating projection 112b with the peripheral detent 110.

Figure 2B shows a rear face 103 of the cam 100, also in the open position. The rear face 103 comprises a rear recess 116 and a spacer 118. The rear recess 116 defines a cam profile defining movement of the lower latch 204 from an open to a closed position, as described in more detail below. The rear recess 116 comprises an upper surface 308, a detent 306 at one end of the profile and a wall 305 at the other.

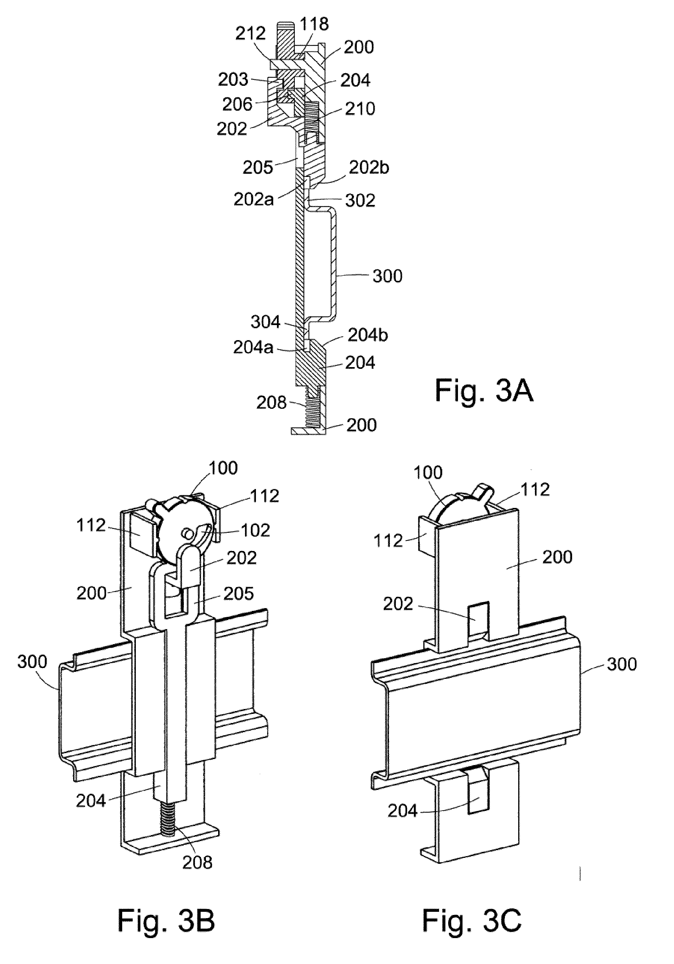

The mounting latch may be further understood with reference to Figures 3A - 3C in which it is in the "open" position on the DIN rail 300. The upper latch 202 in driven by the profile of the front recess 102 of the cam 100 via engagement of an upper follower 203 at an end of the upper latch 202. The upper follower 203 may take the form of a protrusion extending from the upper latch 202 and shaped to sit within the front recess 102. The upper latch 202 is connected to the body 200 via a biasing means such as a spring 210 which acts to bias the upper latch 202 into an engaged position with respect to the edge of the DIN rail 300. The biasing causes the upper latch 202 to follow the profile of front recess 102 as the cam 100 is rotated.

Figure 3A also shows the lower latch 204, which moves in the opposite direction to the upper latch 202 as the cam 100 moves. The lower latch 204 is driven by the profile of the rear recess 116 of the cam 100 via engagement of a lower follower 206 at an end of the lower latch 204. The lower follower 206 may take the form of a protrusion extending from the lower latch 204 and shaped to sit within the rear recess 116. The lower latch 204 also comprises a cut-out portion 205 through which the part of the upper latch 202 carrying the upper follower 203 projects (see Figure 3B). The lower latch 204 is connected to the housing 200 via biasing means such as a spring 208 which biases the lower latch 204 into an engaged position with respect to the lower edge of the DIN rail 300. As with the upper latch 202, the biasing causes the lower latch 204 to follow the profile of the rear recess 116 as the cam 100 is rotated.

The spacer 118 of the rear face 103 of the cam 100 is a raised region around the pivot hole 106 which prevents the cam rear face 103 from lying flush with the housing 200, thereby providing a space for the lower latch 204 to be located between the rear face 103 and the housing 200.

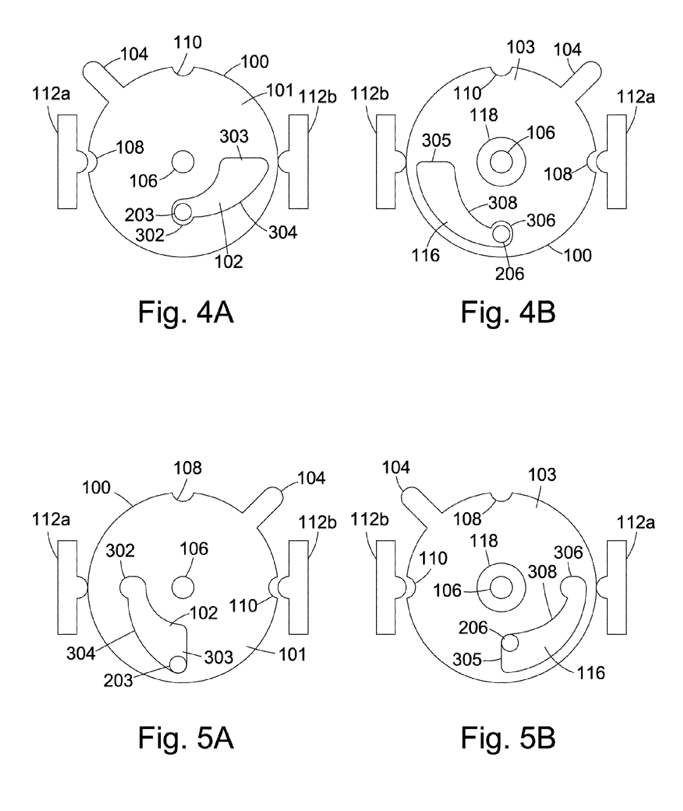

Figures 4A and 4B show the engagement of the upper and lower followers 203 and 206 with the cam 100 when the cam 100 is in the open position. In Figure 4A, upper follower 203 is located in the leading bulbous detent 302 of the front recess 102. Since the upper latch 202 is biased radially away from the pivot hole 106 by the spring 210, the detent 302 of the front recess 102 ensures that the cam 100 is held in the open position.

Similarly, Figure 4B shows the lower follower 206 located within the trailing bulbous detent 306 of the rear recess 116. Since the lower latch 204 is biased radially towards the pivot hole 106, the detent 306 ensures that the lower follower 206 and cam 100 are also held in the open position.

Figures 5A and 5B show the cam 100 in the closed position. In comparison with Figure 4A, Figure 5A shows the front face 101 of the cam 100 rotated clockwise. Upon rotation of the cam 100 via the protrusion 104, the peripheral detent 108 disengages from the locating projection 112a, and the cam 100 is rotated until the peripheral detent 110 engages with the locating projection 112b. The eventual engagement of the peripheral detent 110 with the locating projection 112b defines the "closed" position of the cam 100. With movement of the cam 100, the upper follower 203 travels along the lower surface 304 of the front recess 102 until it abuts the wall 303. At this point, further clockwise rotation of the cam 100 is prevented.

Similarly, Figure 5B shows the position of the rear face 103 of the cam 100 when the same cam 100 is in the "closed" position. In comparison with Figure 4B, when the rear face 103 of the cam 100 is rotated anti-clockwise, the peripheral detent 108 disengages from the locating projection 112a until the peripheral detent 110 engages with the locating projection 112b. With this movement of the cam 100, the lower follower 206 travels along the upper surface 308 of the rear recess 116 until it abuts the wall 305.

The engagement of the peripheral detent 108 with the locating projection 112a, and the engagement of the peripheral detent 110 with the locating projection 112b not only define the open and closed positions respectively of the cam 100, but also provide tactile feedback to an operator that the cam 100 has completed its rotation. Therefore, the operator knows when the cam 100 is locked fully open or closed.

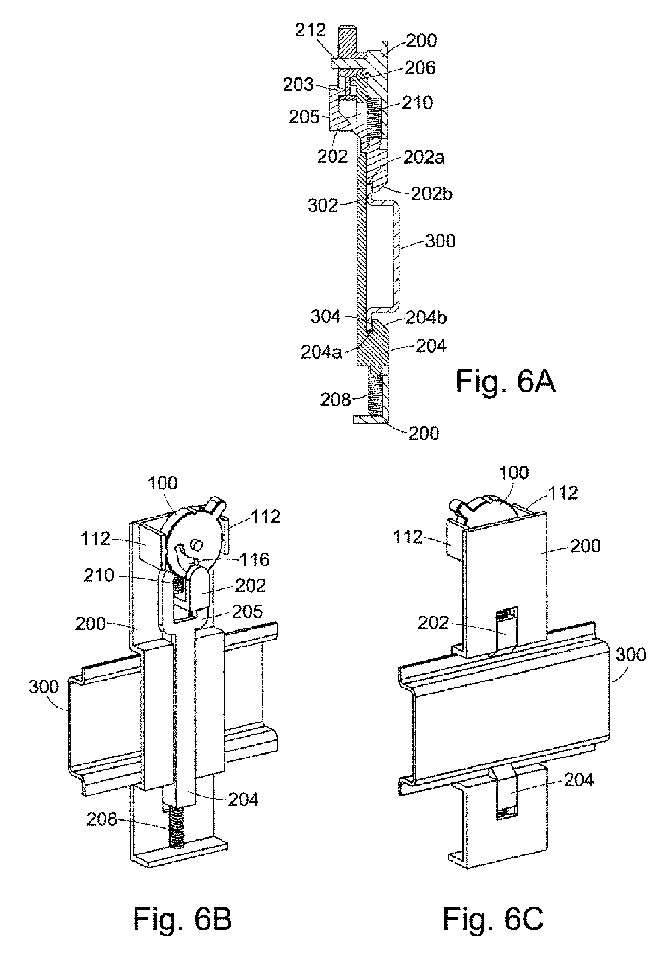

Figures 6A-6C show the mounting latch mounted on the DIN rail 300 in the closed position. With reference to Figure 5A, when the cam 100 is in the corresponding closed position, the upper follower 203 is no longer seated in the detent 302, but abuts the wall 303 of the front recess 102, as previously described. Since the upper follower 203 is biased radially away from the pivot hole 106 of the cam 100, the profile of the front recess 102 means that the upper latch 202 is urged radially further away from the centre of the cam 100 by the spring 210. Conversely, with reference to Figure 5B, since the lower follower 206 of the lower latch 204 is biased radially towards the pivot hole 106 of the cam 100, the profile of the rear recess 116 means that the lower latch 204 is urged radially towards the centre of the cam 100 by the spring 208.

Engagement of the upper latch 202 and lower latch 204 with the DIN rail 300 will now be described. As shown in Figures 3A and 6A, the upper latch 202 is shaped to define an upper latch recess 202a and a chamfered face 202b. The lower latch 204 is shaped to define a lower recess 204a and a chamfered face 204b. The DIN rail 300 is of standard "top hat" shape and comprises upper and lower flanges 302 and 304. There are two methods of mounting the latch onto the DIN rail 300. The first method is to set the upper and lower latches 202 and 204 in the open position by adjustment of the cam 100 as previously described. The mounting latch may then be mounted on the DIN rail 300 by offering it directly onto the DIN rail 300 such that the DIN rail 300 is between the upper latch 202 and lower latch 204. By rotating the cam 100 from the open position to the closed position, the movement of the upper latch 202 and the lower latch 204 towards each other engages the flanges 302 and 304 within the upper and lower recesses 202a and 204a respectively. The mounting latch is then securely mounted on the DIN rail 300 as shown in Figure 6A.

The second method of mounting the mounting latch to the DIN rail 300 is to start with the cam 100 and the upper and lower latches 202 and 204 in the closed position but not mounted on the DIN rail 300. The mounting latch may then be positioned such that the upper and lower flanges 302 and 304 of the DIN rail 300 make contact with the respective chamfered faces 202b and 204b of the upper and lower latches 202 and 204. By exerting a force perpendicular to the plane of the DIN rail 300, the upper and lower latches 202 and 204 yield against their respective bias springs 210 and 208 and engage the flanges 302 and 304 in the upper and lower recesses 202a and 204a.

This movement of the upper and lower latches 202 and 204 against the bias of their respective springs 210 and 208 is possible due to the shape of the front recess 102 and the rear recess 116. As previously described, when the mounting latch is pushed against the DIN rail 300 in a direction perpendicular to the plane of the DIN rail 300, the upper latch 202 is forced to move radially towards the pivot hole 106, against the bias of the spring 210. When this happens, the upper follower 203 rides in a dead space and travels radially across the leading wall 303, away from the lower surface 304 (see Figure 5A). Likewise the lower latch 204 is forced radially away from the pivot hole 106. The lower follower 206 rides in its dead space along the trailing wall 305 away from the upper surface 308. When the upper and lower latches 202 and 204 have moved beyond the respective flanges 302 and 304, they are able to snap back by the force of their respective springs 210 and 208 so that the flanges 302 and 304 are engaged in their recesses 202a and 204a, as shown in Figure 6A.

By using the second method of mounting the mounting latch to the DIN rail 300, the mounting latch may be "snap-fitted" to the DIN rail 300. In both cases the movement of the upper and lower latches 202 and 204 into engagement with the DIN rail 300 is essentially linear and perpendicular to the DIN rail 300. However, the upper latch 202 and lower latch 204 need not be simultaneously "snap-fitted" to the DIN rail 300 as described, and instead the upper latch 202 may first be fitted to the DIN rail 300, followed by the lower latch 204, or vice-versa. Indeed only one of the upper latch 202 or lower latch 204 may be moveable and capable of snap-fitting, and the other may be fixed. Removal of the mounting latch is accomplished by rotating the cam 100 to move the upper latch 202 and lower latch 204 apart.

The cam 100 and upper and lower latches 202 and 204 can be made of any suitable materials that provide the necessary strength and rigidity. Such materials include injection moulded polymers, die-cast aluminium and zinc alloys, or the components may be machined from steel or brass.

Thus a simple and efficient mounting latch is disclosed. Advantageously, since the latch may be snap-fitted to a rail, the latch may be easily fitted in situations where there is limited space to operate or there are other devices obstructing easy access. Further, since no tools are required to attach the latch to the rail, quick and easy installation and removal is achieved. Yet further, there is no need to access the rear of an electrical enclosure since the latch may be easily attached to the rail via "snap-fitting" or through use of the protrusion 104 via the top of the enclosure to manually rotate the cam 100, which requires minimal space to achieve.

The simplicity of the latch means that further space is saved since few parts are needed to construct the latch, while maintaining the latch to be as small as possible and with the required strength to ensure a secure mounting of devices on a rail.

Whilst a particular embodiment has been shown in the figures, variants are possible without departing from the inventive concepts described herein. For example, the DIN rail 300 need not be a top hat shaped DIN rail, but may be another rail configuration. In such circumstances, the shapes and positions of the front guiding 102 and rear recess 116 may be adjusted to accommodate the different rail configuration. The protrusion 104 may be any shape such as a handle or tactile surface that enables actuation of the cam 100 by an operator.

These and/or other physical features of the particular embodiment described herein may be omitted or may be replaced by alternative features which serve the same (or similar) purpose of mounting a device to a rail.

The relative terms "upper", "lower", "front", "rear", "outwardly", "towards", "away from", "anticlockwise", "clockwise", "top" and "bottom" used herein relate to the orientation of the device as shown in the Figures and are employed to facilitate description of the device. They are not intended to be limiting. The use of clockwise and anticlockwise rotation for opening and closing the mounting latch is not limiting and could be reversed instead.

## Claims

1. A mounting latch for mounting a device to a rail comprising:
a moveable actuator having a profile;
a latch mechanism comprising first and second opposed rail engaging members, at least one of the members having a face for causing the member to yield against bias means when the latch mechanism is engaging with the rail; and
follower means enabling the at least one member to follow a rotational movement of the actuator such that movement of the actuator in a first direction causes the at least one member to become unlatched from the rail.

2. The mounting latch of claim 1 wherein the face of the at least one member is a chamfered face.

3. The mounting latch of claim 1 or 2 wherein movement of the moveable actuator in a second, opposite direction causes the at least one member to latch on to the rail.

4. The mounting latch of any preceding claim wherein the profile of the moveable actuator engages with the follower means.

5. The mounting latch of any preceding claim wherein the profile of the moveable actuator comprises a detent for retaining the at least one member in a fixed position.

6. The mounting latch of any preceding claim wherein the bias means comprise a resilient member.

7. The mounting latch of claim 6 wherein the bias means are a spring.

8. The mounting latch of any preceding claim wherein the profile is shaped to enable movement of the at least one member against the bias without movement of the actuator.

9. The mounting latch of any preceding claim wherein the profile comprises first and second profiles on opposite sides of the moveable actuator, and wherein the follower means comprise first and second follower means for enabling respective first and second members to follow the movement of the moveable actuator.

10. The mounting latch of claim 9 wherein the first follower means engage with the first profile, and the second follower means engage with the second profile.

11. The mounting latch of claims 9 or 10 wherein the first and second profiles comprise respective first and second detents for retaining the respective first and second members in a fixed position.

12. The mounting latch of any of claims 9 to 11 wherein the first and second profiles are shaped to allow movement of the respective first and second members against the bias means without movement of the moveable actuator.

13. The mounting latch of any preceding claim comprising a pair of opposed latch mechanisms oppositely moveable between latched and unlatched positions with respect to the rail.
